# EUROPEAN PATENT SPECIFICATION

(11) **EP 0 466 442 B1**
(45) Date of publication and mention of the grant of the patent: **03.12.1997**
(21) Application number: 91306193.3
(22) Date of filing: 08.07.1991
(51) Int. Cl.: H04B 1/62, H04N 5/92, H03G 5/16

(54) **Non-linear preemphasis-deemphasis circuits**
Nichtlineare Preemphasis-Deemphasis-Schaltungen
Circuits non linéaires de pré-accentuation/dé-accentuation

(30) Priority: 09.07.1990 JP 179695/90
(43) Date of publication of application: 15.01.1992
(73) Proprietor: SONY CORPORATION, Tokyo 141 (JP)
(72) Inventor: Sakamoto, Etsurou, c/o Patents Division, Shinagawa-ku, Tokyo 141 (JP)
(74) Representative: Cotter, Ivan John

(56) References cited:
- DE-A- 3 206 047
- US-A- 4 451 746
- PATENT ABSTRACTS OF JAPAN vol. 1, no. 162 (E-077) 21 December 1977 & JP-A-52 108 711
- PATENT ABSTRACTS OF JAPAN vol. 2, no. 40 (E-022) 16 March 1978 & JP-A-53 005 909

## Description

This invention relates to preemphasis circuits and complementary deemphasis circuits which may be suitable for use in a recording/playback apparatus such as a video or audio tape recorder, or a communication equipment.

In a video tape recorder, for example, preemphasis is performed on the recording side and deemphasis is performed on the playback side to enhance the signal-to-noise ratio in recording and playback operations on a magnetic tape. Such preemphasis and deemphasis are also used for improving the signal-to-noise ratio in a signal transfer circuit in a communication system.

As compared with the preemphasis for increasing the amplitude of a signal component higher than a predetermined frequency, a circuit with a limiter inserted therein is termed a non-linear preemphasizer where the signal amplitude to be increased is limited to a predetermined threshold level. The present invention relates to such a non-linear preemphasis circuit and a complimentary non-linear deemphasis circuit for improving the distortion characteristic resulting from non-linearity.

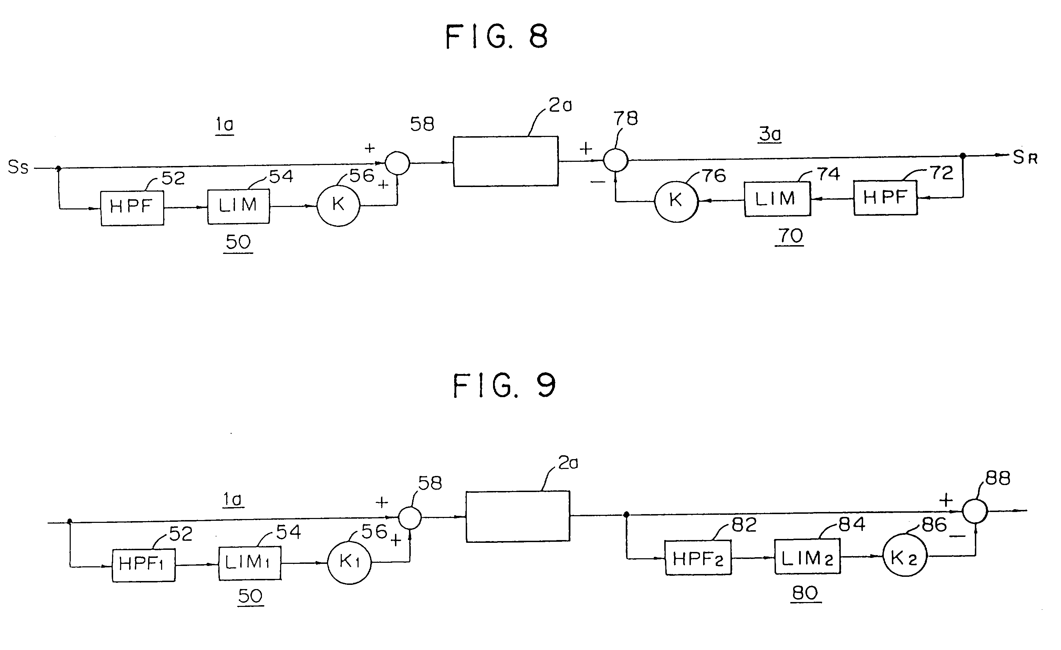

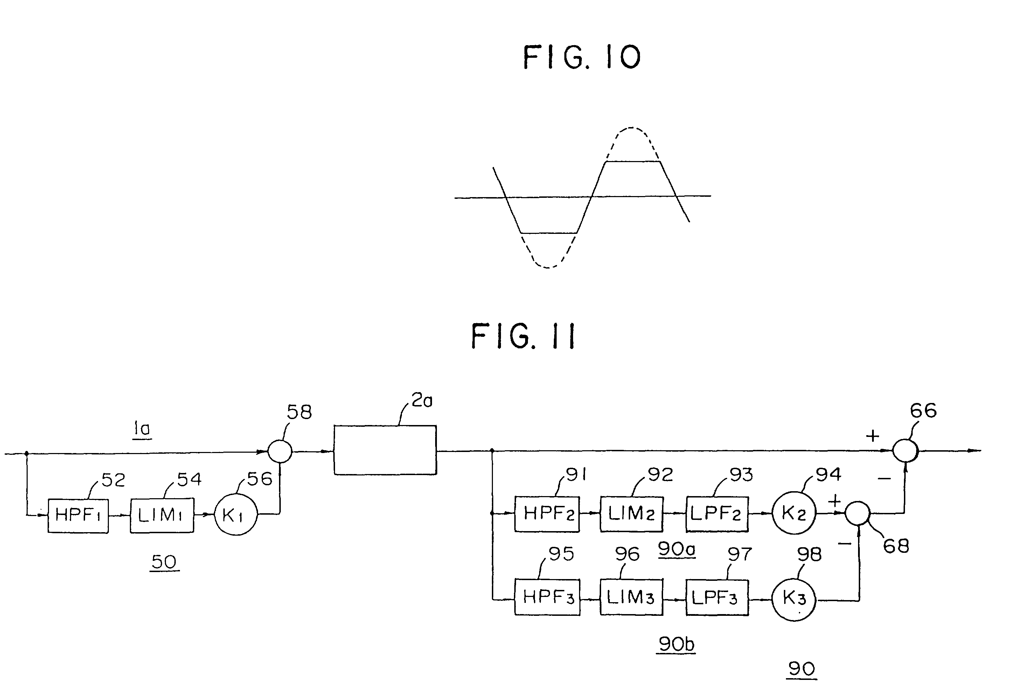

Figure 8 is a block diagram of a previously proposed system comprising a non-linear preemphasis circuit and a non-linear deemphasis circuit. In a video tape recorder taken as an example, its recording section 1a includes a non-linear preemphasis circuit 50 which comprises a high-pass filter 52, a limiter 54, a signal increaser (or a coefficient multiplier) 56 and an adder 58. The high-pass filter 52 passes therethrough merely a predetermined high frequency component of an original signal Sₛ, and the limiter 54 limits to a predetermined threshold level the amplitude of the signal component passed through the high-pass filter 52, as graphically shown in Figure 10. The signal increaser 56 serves to increase the output of the limiter 54 in accordance with the frequency of the signal component. Such non-linear preemphasis circuit 50 prevents, via the limiter 54, further amplification of the output of the high-pass filter 52 beyond a predetermined level. The increased signal component higher than the predetermined frequency of the original signal Sₛ is supplied to the adder 58 so as to be added to the original signal Sₛ. The signal thus obtained is supplied as a recording signal to a recording/playback section 2a, where the signal is recorded on a magnetic tape, and then is read out therefrom to be reproduced in a playback section 3a. In this example, the recording/playback section 2a comprises a recording head, a magnetic tape, a playback head and an amplifier. The playback section 3a includes a non-linear deemphasis circuit 70 comprising a subtracter 78, a high-pass filter 72, a limiter 74 and a coefficient multiplier 76 for decreasing the amplitude of a signal component which corresponds to the increase obtained in the recording section 1a. The deemphasis circuit 70 is formed as a inversion of the non-linear preemphasis circuit 50.

The circuits in the playback section 3a of Figure 8 have a faithful inverse circuit configuration with respect to the recording section 1a, so that the inverse characteristic is superior. However, due to the negative feedback circuit configuration, there exists a problem that high stability is not achievable over a wide frequency range. Also, it is not suited to formation as an IC.

Figure 9 shows an improvement of the non-linear deemphasis circuit of Figure 8. For the purpose of solving the problem arising from the negative feedback circuit configuration in the example of Figure 8, a non-linear deemphasis circuit 80 shown in Figure 9 comprises a high-pass filter 82, a limiter 84 and a coefficient multiplier 86 which are so connected as to form a feedforward configuration to an adder 88. The high-pass filter 82, the limiter 84 and the coefficient multiplier 86 are so designed as to have an inverse characteristic relative to that of the non-linear preemphasis circuit 50.

The non-linear deemphasis circuit 80 of Figure 9 has a flat frequency characteristic with small distortion in a low frequency range (linear area) where the amplitude is not limited by the limiters 54 and 84. However, distortion occurs in the non-linear area where the signal amplitude is limited by the limiters 54 and 84, as graphically shown in Figure 10.

Figure 11 shows the configuration of another non-linear deemphasis circuit intended to solve the above problem. The non-linear deemphasis circuit 90 in Figure 11 comprises a parallel connection of two non-linear deemphasis circuits 90a and 90b for mutually different frequency components. In this example, a signal component of one frequency band is passed through a high-pass filter 91 and a low-pass filter 93 in the first deemphasis circuit 90a, and is then decreased by a coefficient multiplier 94. Meanwhile a signal component of another frequency band, which is different from that of the first deemphasis circuit 90a, is passed through a high-pass filter 95 and a low-pass filter 97 in the second deemphasis circuit 90b, and is then decreased by a coefficient multiplier 98. The two decreased signal components of mutually different frequency bands are added to each other by an adder 68.

The non-linear deemphasis circuit 90 shown in Figure 11 has a feedforward configuration to perform deemphasis in accordance with the frequency band, so that the distortion characteristic thereof can be improved. However, there arises a problem that its circuit configuration is complicated.

DE-A-3206047 discloses a non-linear preemphasis-deemphasis circuit employing a non-linear feedback circuit for preemphasis in conjunction with a non-linear feedforward deemphasis circuit. In the deemphasis circuit, the signal is fed through a high-pass filter, a compression circuit and a damping circuit and then subtracted from the original signal.

According to the present invention there is provided a non-linear preemphasis circuit comprising:
a non-linear signal increasing means (10) comprising filtering means (10a) for selecting signal components having a frequency higher than a predetermined frequency and a non-linear amplifying means (10b, 10c) for increasing the amplitude of said signal components and for limiting the amplitude of said signal components to be no more than a predetermined level;
a first adder (14) for adding the output of said non-linear signal increasing means (10) to the original signal;
a non-linear signal decreasing means (16) having a signal decreasing characteristic which is the inverse of the non-linear signal increasing characteristic of said non-linear signal increasing means (10), the input of said non-linear signal decreasing means (16) being connected to the output of said first adder (14); and
a second adder (20a) for adding the output of said signal decreasing means (16) to the original signal.

A non-linear preemphasis-deemphasis system embodying the invention also includes: a non-linear deemphasis circuit complimentary to said non-linear preemphasis circuit and connected thereto via a signal transferer, said deemphasis circuit comprising a non-linear deemphasis circuit complimentary to said non-linear preemphasis circuit and connected thereto via a signal transferer (2), said deemphasis circuit comprising a non-linear signal decreasing means (30) comprising filtering means (30a) for selecting signal components having a frequency higher than a predetermined frequency and a non-linear amplifying means (30b, 30c) for decreasing the amplitude of said signal component and for limiting the amplitude of said signal components to be no more than a predetermined level, and a subtracter (34a) for subtracting the output of said signal decreasing means (30) from the received signal.

In contrast to the previously proposed method which improves the distortion characteristic in a playback (receiving) section by eliminating the distortion caused therein, embodiments of the invention are based on the concept of simplifying the circuit configuration in combination with the known advantage of a feedforward deemphasis circuit in the playback section, wherein an amount corresponding to the distortion component is previously added in a recording (transmitting) section consequently to achieve reduction of the distortion in the entire preemphasis-deemphasis system.

One embodiment of the present invention forms a non-linear preemphasis-deemphasis system consisting of non-linear preemphasis and deemphasis units. The preemphasis unit comprises a non-linear signal increasing means for increasing the amplitude of a signal component higher than a predetermined frequency of an original signal to a predetermined threshold level in accordance with the frequency, a first adder means for adding the output of the non-linear signal increasing means to the original signal, a signal decreasing means having a characteristic inverse to the increasing characteristic of the non-linear signal increasing means, and a second adder means for adding the output of the signal decreasing means to the original signal. The deemphasis unit is connected via signal transferer to the non-linear preemphasis unit and comprises a non-linear signal decreasing means having a characteristic inverse to the increasing characteristic of the non-linear signal increasing means in the preemphasis unit and serving to decrease the amplitude of the signal component higher than the predetermined frequency of the received signal to a predetermined threshold level, and a subtracter for subtracting the output of the signal decreasing means from the received signal.

Since the non-linear signal decreasing means has a characteristic inverse to that of the non-linear signal increasing means and is so connected as to form a feedforward circuit configuration, the known problem of the negative feedback circuit configuration does not arise in the signal receiving section, consequently to ensure high stability.

In the non-linear preemphasis unit, the first adder means and the signal decreasing means calculate and add a correction signal to the original signal. Such correction signal is used for correcting any non-linear distortion that may be caused when the signal amplitude is limited to a predetermined threshold level by the limiter in the non-linear signal increasing means. Since such added correction signal component is transferred to the signal receiving section, the distortion can be corrected therein despite the limitation of the received signal. Consequently it becomes possible to obtain an undistorted playback signal in the signal receiving section.

The invention will now be described by way of example with reference to the accompanying drawings, throughout which like parts are referred to by like references, and in which:

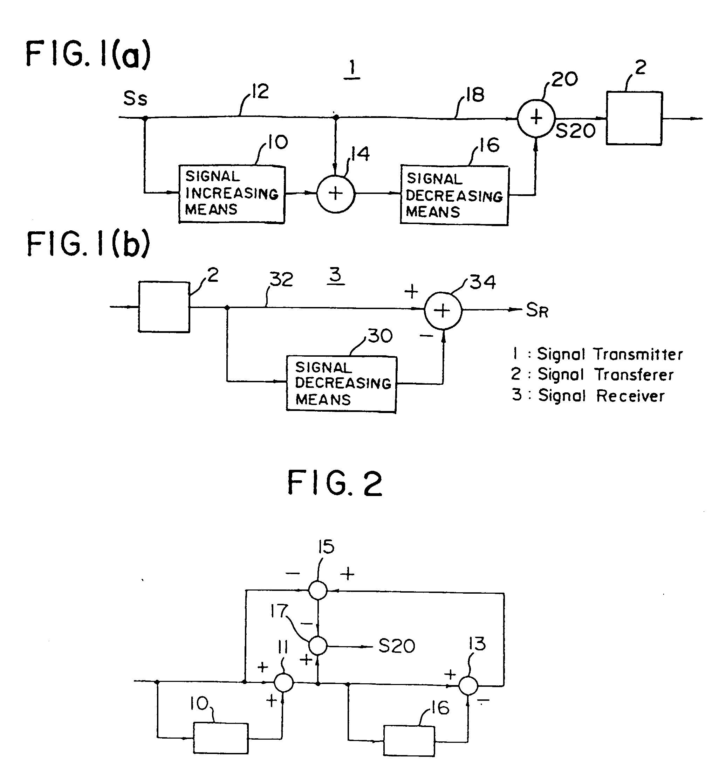

Figure 1 is a block diagram of an embodiment of non-linear preemphasis-deemphasis system according to the present invention;
Figure 2 is an equivalent block diagram of a non-linear preemphasis circuit in the system of Figure 1;
Figure 3 is a circuit block diagram of a non-linear preemphasis circuit and a non-linear deemphasis unit;
Figure 4 shows an analogue circuit configuration of a high-pass filter and a coefficient multiplier in Figure 3;
Figure 5 graphically shows the characteristic of a limiter in Figure 3;
Figure 6 graphically shows the characteristics of the nonlinear preemphasis circuit and the non-linear deemphasis circuit of Figure 3;
Figure 7 shows digital circuit configuration of the high-pass filter and the coefficient multiplier in Figure 3;
Figures 8 and 9 are block diagrams of previously proposed non-linear preemphasis-deemphasis systems;
Figure 10 graphically shows how a signal amplitude is limited by means of a limiter; and
Figure 11 is a block diagram of another previously proposed non-linear preemphasis-deemphasis system.

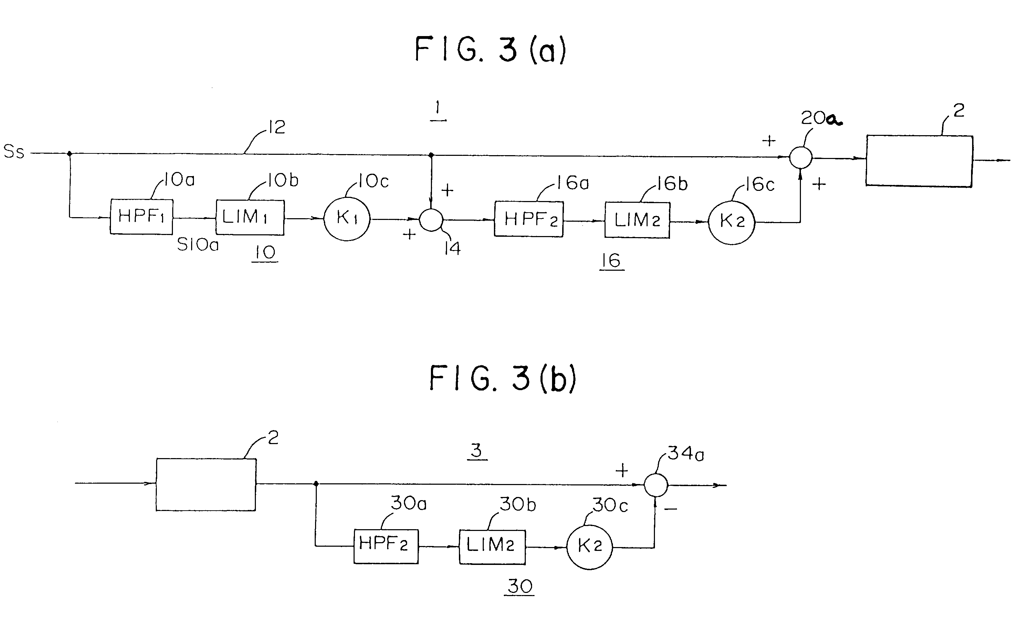

Figure 3 (Figures 3a and 3b) is a block diagram of a nonlinear preemphasis-deemphasis system which comprises a non-linear preemphasis circuit and a non-linear deemphasis circuit, applied to a video tape recorder. The non-linear preemphasis circuit is provided in a recording section 1, and the non-linear deemphasis circuit is provided in a playback section 3 via a recording/playback section 2.

A signal increasing means 10 in the non-linear preemphasis circuit includes a first high-pass filter 10a, a first limiter 10b and a coefficient multiplier 10c. The first limiter 10b and the coefficient multiplier 10c may be disposed in the reverse order.

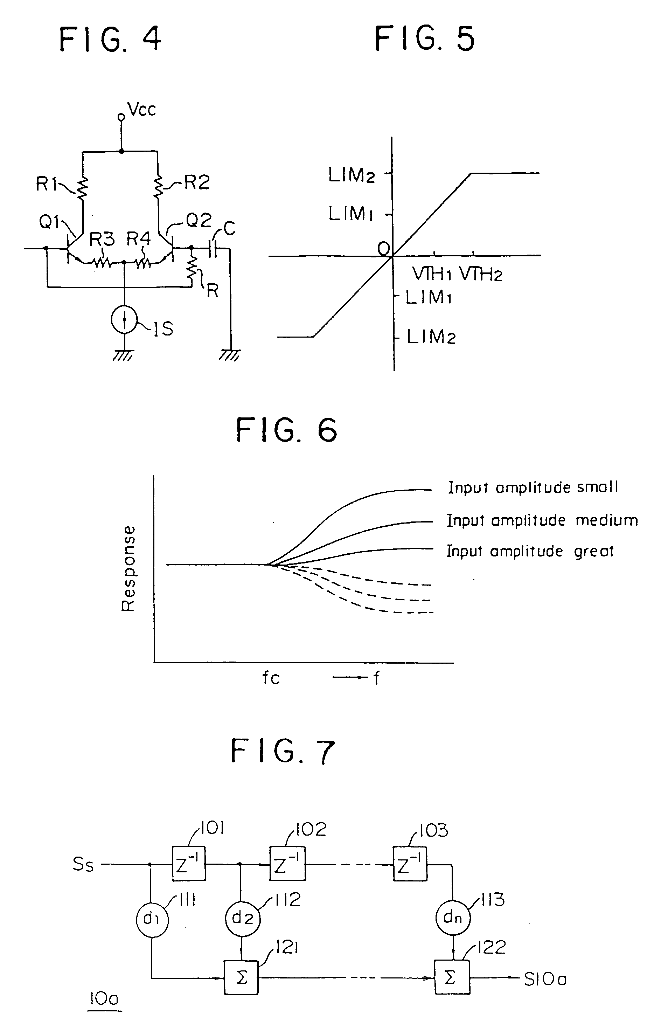

Figure 4 shows an exemplary circuit configuration of the first high-pass filter 10a and the coefficient multiplier 10c. The example of Figure 4, a low-pass filter comprising a resistor R and a capacitor C is connected to a circuit comprising a differential pair of transistors Q1 and Q2, resistors R1 to R4, and a current source IS. When an input signal is applied to the base of the transistor Q1, a signal-amplitude increasing signal determined by the amplification factor of the transistor Q1 corresponding to the amplification coefficient k1 of the coefficient multiplier 10c is supplied from the collector of the transistor Q2. Figure 5 graphically shows the limiting characteristic of the first limiter 10b. The first limiter 10b serves to limit the signal voltage at its threshold voltage V_{TH1}. The limiting characteristic is set to be symmetrical on the negative side also with respect to the origin point 0.

As shown in Figure 3, a signal decreasing means 16 in the non-linear preemphasis circuit includes a second high-pass filter 16a, a second limiter 16b and a coefficient multiplier 16c. The second limiter 16b and the coefficient multiplier 16c may be disposed in the reverse order. The non-linear signal decreasing characteristic of the signal decreasing means 16 is so designed as to be inverse to the characteristic of the non-linear signal increasing means 10. The second high-pass filter 16a and the coefficient multiplier 16c are similar to the circuit configuration of Figure 4. However, transistors Q1 and Q2 forming the coefficient multiplier 16c are so designed as to decrease the signal by a second coefficient k2 instead of amplifying the signal. Figure 5 shows the characteristic of the second limiter 16b which serves to limit the signal voltage at its threshold voltage V_{TH2}.

A first adder 14 adds the output of the non-linear signal increasing means 10 to the original signal Sₛ, and a second adder 20a adds the output of the signal decreasing means 16 to the original signal Sₛ. The non-linear preemphasis characteristic of the above-described non-linear preemphasis circuit is represented by solid lines in Figure 6, and the deemphasis characteristic thereof is represented by broken lines.

The output of the second adder 20a is recorded on a magnetic tape via a recording head (not shown).

Since the non-linear preemphasis circuit of Figure 3 comprises merely the signal decreasing means 16 and the second adder 20a, the circuit configuration is simplified.

The non-linear deemphasis unit of Figure 3 includes a nonlinear signal decreasing means 30 comprising a third high-pass filter 30a, a third limiter 30b, a coefficient multiplier 30c, and a signal subtracter 34a. The non-linear deemphasis circuit is similar in circuit configuration to the signal decreasing means 16, and the second adder 20a of the feedforward non-linear preemphasis circuit. A playback signal S_{R} is obtained from this non-linear deemphasis circuit.

Now an exemplary circuit configuration of the non-linear preemphasis circuit applied to a digital communication system will be described.

The first high-pass filter 10a and the coefficient multiplier 10c shown in Figure 3 are formed of a plurality of series-connected stages, for example, five stages, of transversal filters each comprising, as shown in Figure 7, a unitary delay element 101, a coefficient multiplier 112, an adder 121, a unitary delay element 103, a coefficient multiplier 113 and an adder 122. Each of coefficients α1 to αn at the individual taps of this transversal filter determines the pass frequency of the high-pass filter 10a and the first coefficient kl. The first limiter 10b also has the characteristic of Figure 5.

The second high-pass filter 16a and the coefficient multiplier 16c shown in Figure 3 are also similar to the circuit configuration of Figure 7. However, the coefficients αl to αn thereof are different from those of the first high-pass filter 10a and the coefficient multiplier 10c.

The non-linear signal decreasing means 30 is similar in circuit configuration to the aforementioned signal decreasing means 16.

In forming the non-linear preemphasis and deemphasis circuits, a variety of modifications are possible. For example, in place of an analogue circuit or a digital integrated circuit employed in the embodiment, a DSP (digital signal processor) or the like may be used to form the entirety of each of the aforementioned non-linear signal increasing means 10, first adder 14, signal decreasing means 16 and second adder 20 in the non-linear preemphasis unit. Similarly, a digital signal processor may be used for the non-linear deemphasis unit as well.

With the non-linear preemphasis system described above, a distortion-correction playback signal can be obtained in a simplified circuit configuration over a wide frequency band in its playback (receiving) section. Moreover, in the non-linear deemphasis circuit stable operation is ensured.

## Claims

1. A non-linear preemphasis circuit comprising:
a non-linear signal increasing means (10) comprising filtering means (10a) for selecting signal components having a frequency higher than a predetermined frequency and a non-linear amplifying means (10b, 10c) for increasing the amplitude of said signal components and for limiting the amplitude of said signal components to be no more than a predetermined level;
a first adder (14) for adding the output of said non-linear signal increasing means (10) to the original signal;
a non-linear signal decreasing means (16) having a signal decreasing characteristic which is the inverse of the non-linear signal increasing characteristic of said non-linear signal increasing means (10), the input of said non-linear signal decreasing means (16) being connected to the output of said first adder (14); and
a second adder (20a) for adding the output of said signal decreasing means (16) to the original signal.

2. A non-linear preemphasis-deemphasis system comprising:
a non-linear preemphasis circuit according to claim 1; and
a non-linear deemphasis circuit complimentary to said non-linear preemphasis circuit and connected thereto via a signal transferer (2), said deemphasis circuit comprising a non-linear signal decreasing means (30) comprising filtering means (30a) for selecting signal components having a frequency higher than a predetermined frequency and a non-linear amplifying means (30b, 30c) for decreasing the amplitude of said signal components and for limiting the amplitude of said signal components to be no more than a predetermined level, and a subtracter (34a) for subtracting the output of said signal decreasing means (30) from the received signal.

3. A system according to claim 2 wherein said non-linear signal decreasing means (30) of said non-linear deemphasis circuit has a signal decreasing characteristic which is the inverse of the signal increasing characteristic of said non-linear signal increasing means (10) in said non-linear preemphasis circuit.

## Patentansprüche

1. Nichtlineare Preemphasisschaltung, bestehend aus
einer nichtlinearen Signalanhebungseinrichtung (10) mit einer Filtereinrichtung (10a) zur Auswahl von Signalkomponenten, deren Frequenz über einer vorbestimmten Frequenz liegt, und einer nichtlinearen Verstärkungseinrichtung (10b, 10c) zum Anheben der Amplitude der Signalkomponenten und zum Begrenzen der Amplitude der Signalkomponenten derart, daß diese einen vorbestimmten Pegel nicht überschreitet,
einem ersten Addierer (14) zum Addieren des Ausgangssignals der nichtlinearen Signalanhebungseinrichtung (10) zu dem ursprünglichen Signal,
einer nichtlinearen Signalabsenkungseinrichtung (16) mit einer zu der nichtlinearen Signalanhebungskennlinie der nichtlinearen Signalanhebungseinrichtung inversen Signalabsenkungskennlinie, wobei der Eingang der nichtlinearen Signalabsenkungseinrichtung (16) mit dem Ausgang des ersten Addierers (14) verbunden ist, und
einem zweiten Addierer (20) zum Addieren des Ausgangssignals der Signalabsenkungseinrichtung (16) zu dem ursprünglichen Signal.

2. Nichtlineares Preemphasis-Deemphasis-System, bestehend aus
einer nichtlinearen Preemphasisschaltung nach Anspruch 1, und
einer zu dieser nichtlinearen Preemphasisschaltung komplementären und mit ihr über einen Signalübertrager (2) verbundenen nichtlinearen Deemphasisschaltung, wobei diese Deemphasisschaltung eine nichtlineare Signalabsenkungseinrichtung (30) aufweist mit einer Filtereinrichtung (30a) zur Auswahl von Signalkomponenten, deren Frequenz über einer vorbestimmten Frequenz liegt, und einer nichtlinearen Verstärkungseinrichtung (30b, 30c) zum Absenken der Amplitude der Signalkomponenten und zum Begrenzen der Amplitude der Signalkomponenten derart, daß diese einen vorbestimmten Pegel nicht überschreitet, und
einem Subtrahierer (34a) zum Subtrahieren des Ausgangssignals der Signalabsenkungseinrichtung (30) von dem empfangenen Signal.

3. System nach Anspruch 2, bei die nichtlineare Signalabsenkungseinrichtung (30) der nichtlinearen Deemphasisschaltung eine zu der Signalanhebungskennlinie der nichtlinearen Signalanhebungseinrichtung (10) in der nichtlinearen Preemphasisschaltung inverse Signalabsenkungskennlinie besitzt.

## Revendications

1. Circuit de pré-accentuation non-linéaire comprenant :
un moyen d'augmentation de signal non-linéaire (10) comprenant un moyen de filtrage (10a) pour sélectionner des composantes de signal ayant une fréquence plus élevée qu'une fréquence prédéterminée et un moyen d'amplification non-linéaire (10b, 10c) pour augmenter l'amplitude desdites composantes de signal et pour limiter l'amplitude desdites composantes de signal pour qu'elles ne soient pas supérieures à un niveau prédéterminé ;
un premier additionneur (14) pour additionner la sortie dudit moyen d'augmentation de signal non-linéaire (10) au signal original ;
un moyen de diminution de signal non-linéaire (16) ayant une caractéristique de diminution de signal qui est l'inverse de la caractéristique d'augmentation de signal non-linéaire dudit moyen d'augmentation de signal non-linéaire (10), l'entrée dudit moyen de diminution de signal non-linéaire (16) étant raccordée à la sortie dudit premier additionneur (14) ; et
un second additionneur (20a) pour additionner la sortie dudit moyen de diminution de signal (16) au signal original.

2. Système de pré-accentuation - désaccentuation non-linéaire comprenant :
un circuit de pré-accentuation non-linéaire selon la revendication 1 ; et
un circuit de désaccentuation non-linéaire complémentaire audit circuit de pré-accentuation non-linéaire et raccordé à celui-ci via un dispositif de transfert de signal (2), ledit circuit de désaccentuation comprenant un moyen de diminution de signal non-linéaire (30) comprenant un moyen de filtrage (30a) pour sélectionner des composantes de signal ayant une fréquence plus élevée qu'une fréquence prédéterminée et un moyen d'amplification non-linéaire (30b, 30c) pour diminuer l'amplitude desdites composantes de signal et pour limiter l'amplitude desdites composantes de signal pour qu'elles ne soient pas supérieures à un niveau prédéterminé, et un soustracteur (34a) pour soustraire la sortie dudit moyen de diminution de signal (30) à partir du signal reçu.

3. Système selon la revendication 2, dans lequel ledit moyen de diminution de signal non-linéaire (30) dudit circuit de désaccentuation non-linéaire a une caractéristique de diminution de signal qui est l'inverse de la caractéristique d'augmentation de signal dudit moyen d'augmentation de signal non-linéaire (10) dans ledit circuit de pré-accentuation non-linéaire.
